# EUROPEAN PATENT APPLICATION

(11) **EP 2 824 707 A1**
(43) Date of publication of application: **14.01.2015**
(21) Application number: 14176075.1
(22) Date of filing: 08.07.2014
(51) Int. Cl.: H01L 25/075

(54) **Lighting component and lighting device**

(30) Priority: 11.07.2013 TW 102124881
(71) Applicant: Everlight Electronics Co., Ltd, New Taipei City 23860 (TW)
(72) Inventor: Wu, Wei-Ting, 23860 New Taipei City (TW)
(74) Representative: Becker, Eberhard

(57) **Abstract**

Various examples of a lighting component and lighting device are described. In one aspect, a lighting component includes a supporting base and a LED die set. The supporting base includes a supporting surface and the LED die set includes at least four LED dies disposed on the supporting surface in a predefined arrangement. In another aspect, a lighting device includes a plurality of lighting components as described above that are arranged in a matrix. Therefore, each LED die of each lighting component defines a pixel, and can jointly define another pixel with one or more neighboring LED dies of one or more neighboring lighting components. Pixel pitch between pixels can thus be reduced.

## Description

### CROSS REFERENCE TO RELATED PATENT APPLICATION

The present disclosure claims the priority benefit of Taiwan Patent Application No. 102124881, filed on 11 July 2013, which is incorporated by reference in its entirety.

### TECHNICAL FIELD

The present disclosure relates to a lighting component and lighting device and, more particularly, to a lighting component and lighting device including one or more light-emitting diode (LED) dies.

### BACKGROUND

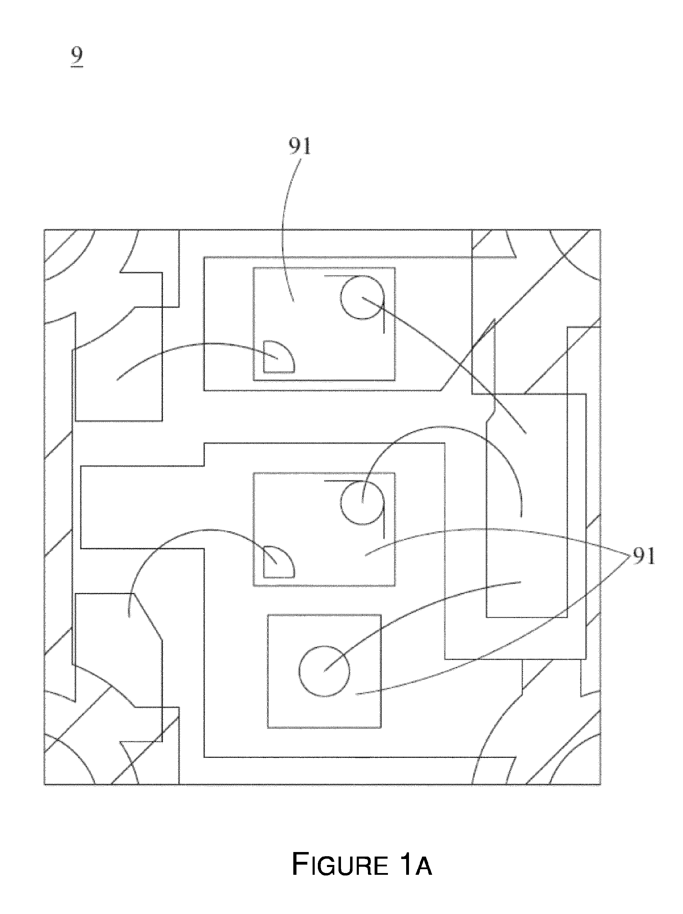

More and more of the lighting components nowadays utilize LED dies as the light source. For example, referring to Figure 1A, LED dies 91 of three different colors are used in lighting component 9 to allow lighting component 9 to emit light of three different colors.

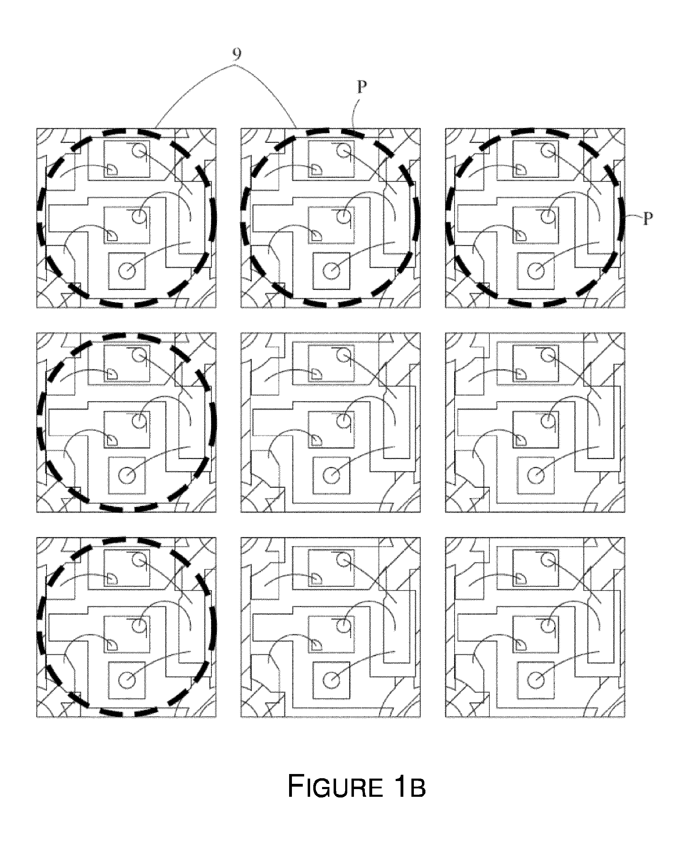

As shown in Figure 1B, numerous lighting components 9 can be arranged to form a lighting device (e.g., electronic signage, display, etc.). Resolution is an important characteristic among the characteristics of such lighting device. The better the resolution of the lighting device is, the finer the picture or image displayed by the lighting device will be to provider better visual experience to a viewer.

To provide better resolution for a lighting device, the pixel pitch between pixels needs to be smaller to allow a greater number of pixels in a given unit of length. However, the pixel pitch in prior art lighting devices can only be greater than or equal to the dimension of lighting component 9 (length or width), not less than the dimension of lighting component 9. This is due to the fact that a single pixel P is formed by one lighting component 9.

In view of this, there is a need in the industry to provide a lighting component and lighting device to remedy the aforementioned deficiency.

### SUMMARY

The present disclosure provides a lighting component employable in lighting devices to improve the resolution of lighting devices.

The present disclosure also provides a lighting device with improved resolution.

In one aspect, one or more lighting components may include a first lighting component which may include a first supporting base and a LED die set. The first supporting base may have a first supporting surface including two distal ends in a first direction and two distal ends in a second direction perpendicular to the first direction. The four distal ends may define a first quadrilateral area. The LED die set may be disposed on the first supporting surface and may include at least a first LED die, a second LED die, a third LED die, and a fourth LED die that are arranged in an array. A distance between the first LED die and the second LED die in the first direction may have a first value X₁. A minimum distance between the first LED die and an edge of the first quadrilateral area may have a second value Y₁₁. A minimum distance between the second LED die and the edge of the first quadrilateral area may have a third value Y₁₂. The first value X₁ may be greater than a sum of the second value X₁ and the third value Y₁₂.

In at least some embodiments, the one or more lighting components may further include a second lighting component which may include a second supporting base having a second supporting surface. The second supporting surface may include two distal ends in the first direction and two distal ends in the second direction. The four distal ends of the second supporting surface may define a second quadrilateral area. A minimum distance between the edge of the first quadrilateral area of the first supporting surface of the first lighting component and an edge of the second quadrilateral area of the second supporting surface of the second lighting component in the first direction may have a fourth value Z₁. A sum of the second value Y₁₁, the third value Y₁₂, and the fourth value Z₁ may be not less than 0.9 times the first value X₁ and not greater than 1.1 times the first value X₁.

In at least some embodiments, the sum of the second value Y₁₁, the third value Y₁₂, and the fourth value Z₁ may be equal to the first value X₁.

In at least some embodiments, a distance between the first LED die and the third LED die in the second direction may have a fifth value X₂. A minimum distance between the first LED die and the edge of the first quadrilateral area may have a sixth value Y₂₁. A minimum distance between the third LED die and the edge of the first quadrilateral area has a seventh value Y₂₂. The fifth value X₂ may be greater than a sum of the sixth value Y₂₁ and the seventh value Y₂₂.

In at least some embodiments, a minimum distance between the edge of the first quadrilateral area of the first supporting surface of the first lighting component and the edge of the second quadrilateral area of the second supporting surface of the second lighting component in the second direction may have an eighth value Z₂. A sum of the sixth value Y₂₁, the seventh value Y₂₂, and the eighth value Z₂ may be not less than 0.9 times the fifth value X₂ and not greater than 1.1 times the fifth value X₂.

In at least some embodiments, the sum of the sixth value Y₂₁, the seventh value Y₂₂, and the eighth value Z₂ may be equal to the fifth value X₂.

In at least some embodiments, the first supporting surface may be quadrilateral in shape. The edge of the first quadrilateral area may include an edge of the first supporting surface.

In at least some embodiments, the first supporting surface may be square in shape.

In at least some embodiments, the first LED die, the second LED die, the third LED die, and the fourth LED die may be arranged as a square matrix.

In at least some embodiments, the first LED die, the second LED die, the third LED die, and the fourth LED die may include one or two red LED dies, one or two green LED dies, one or two blue LED dies, or a combination thereof.

In at least some embodiments, the first value X₁ may be not greater than 1 mm.

In at least some embodiments, the fifth value X₂ may be not greater than 1 mm.

In another aspect, a lighting device may include a plurality of lighting components. Each of the lighting components may respectively include a supporting base and a LED die set. The supporting base may have a supporting surface including two distal ends in a first direction and two distal ends in a second direction perpendicular to the first direction. The four distal ends may define a quadrilateral area. The LED die set may be disposed on the supporting surface, and may include at least a first LED die, a second LED die, a third LED die, and a fourth LED die that are arranged in an array. A distance between the first LED die and the second LED die in the first direction may have a first value X₁. A minimum distance between the first LED die and an edge of the quadrilateral area may have a second value Y₁₁. A minimum distance between the second LED die and the edge of the quadrilateral area may have a third value Y₁₂. The first value X₁ may be greater than a sum of the second value Y₁₁ and the third value Y₁₂. The lighting components may be arranged in an array. A minimum distance between the edge of the quadrilateral area of the supporting surface of the supporting base of a first lighting component of the lighting components and the edge of the quadrilateral area of the supporting surface of the supporting base of a second lighting component of the lighting components neighboring the first lighting component in the first direction may have a fourth value Z₁. A sum of the second value Y₁₁, the third value Y₁₂, and the fourth value Z₁ may be not less than 0.9 times the first value X₁ and not greater than 1.1 times the first value X₁.

In at least some embodiments, a distance between the first LED die and the third LED die may have a fifth value X₂. A minimum distance between the first LED die and the edge of the first quadrilateral area may have a sixth value Y₂₁. A minimum distance between the third LED die and the edge of the first quadrilateral area may have a seventh value Y₂₂. The fifth value X₂ may be greater than a sum of the sixth value Y₂₁ and the seventh value Y₂₂. A minimum distance between the edge of the quadrilateral area of the supporting surface of the supporting base of the first lighting component and the edge of the quadrilateral area of the supporting surface of the supporting base of the second lighting component in the second direction may have an eighth value Z₂. A sum of the sixth value Y₂₁, the seventh value Y₂₂, and the eighth value Z₂ may be not less than 0.9 times the fifth value X₂ and not greater than 1.1 times the fifth value X₂.

In yet another aspect, one or more lighting components may include a first lighting component which may include a first supporting base and an LED die set. The first supporting base may have a first supporting surface including two distal ends in a first direction and two distal ends in a second direction perpendicular to the first direction. The four distal ends may define a first quadrilateral area. The LED die set may be disposed on the first supporting surface, and may include at least six LED dies that are arranged in an array. A distance between two neighboring LED dies of the LED die set in the first direction may have a first value X₁. A minimum distance between LED dies of the LED die set on a first side and an edge of the first quadrilateral area may have a second value Y₁₁. A minimum distance between LED dies of the LED die set on a second side opposite the first side and the edge of the first quadrilateral area may have a third value Y₁₂. The first value X₁ may be greater than a sum of the second value Y₁₁ and the third value Y₁₂.

In at least some embodiments, the one or more lighting components may also include a second lighting component which may include a second supporting base. The second supporting base may have a second supporting surface including two distal ends in the first direction and two distal ends in the second direction. The four distal ends of the second supporting surface may define a second quadrilateral area. A minimum distance between the edge of the first quadrilateral area of the first supporting surface of the first lighting component and an edge of the second quadrilateral area of the second supporting surface of the second lighting component in the first direction may have a fourth value Z₁. A sum of the second value Y₁₁, the third value Y₁₂, and the fourth value Z₁ may be not less than 0.9 times the first value X₁ and not greater than 1.1 times the first value X₁.

In at least some embodiments, the sum of the second value Y₁₁, the third value Y₁₂, and the fourth value Z₁ may be equal to the first value X₁.

In at least some embodiments, a distance between two other neighboring LED dies of the LED die set in the second direction may have a fifth value X₂. A minimum distance between the LED dies of the LED die set on the first side and the edge of the first quadrilateral area may have a sixth value Y₂₁. A minimum distance between the LED dies of the LED die set on the second side and the edge of the first quadrilateral area may have a seventh value Y₂₂. The fifth value X₂ may be greater than a sum of the sixth value Y₂₁ and the seventh value Y₂₂.

In at least some embodiments, a minimum distance between the edge of the first quadrilateral area of the first supporting surface of the first lighting component and the edge of the second quadrilateral area of the second supporting surface of the second lighting component in the second direction may have an eighth value Z₂. A sum of the sixth value Y₂₁, the seventh value Y₂₂, and the eighth value Z₂ may be not less than 0.9 times the fifth value X₂ and not greater than 1.1 times the fifth value X₂.

In at least some embodiments, the sum of the sixth value Y₂₁, the seventh value Y₂₂, and the eighth value Z₂ may be equal to the fifth value X₂.

Some preferred embodiments are described below with reference to the attached drawings to aid better understanding of the objectives, technical features and advantages of the present disclosure.

### BRIEF DESCRIPTION OF THE DRAWINGS

The accompanying drawings are included to provide a further understanding of the disclosure, and are incorporated in and constitute a part of the present disclosure. The drawings illustrate embodiments of the disclosure and, together with the description, serve to explain the principles of the disclosure. It is appreciable that the drawings are not necessarily in scale as some components may be shown to be out of proportion than the size in actual implementation in order to clearly illustrate the concept of the present disclosure. In the drawings, similar components are labeled with the same numeral references.
Figure 1A is a diagram of a lighting component in the prior art.
Figure 1B is a diagram of a lighting component in the prior art.
Figure 2A is a top view of a lighting component in accordance with a first embodiment of the present disclosure.
Figure 2B is another top view of a lighting component in accordance with the first embodiment of the present disclosure.
Figure 3A is a top view of a lighting component in accordance with another embodiment of the present disclosure (with electrodes not shown).
Figure 3B is a top view of a lighting component in accordance with another embodiment of the present disclosure.
Figure 4 is a top view of a lighting device in accordance with a second embodiment of the present disclosure.
Figure 5A is a top view of a lighting device in accordance with a variation of the second embodiment of the present disclosure.
Figure 5B is a top view of a lighting device in accordance with another variation of the second embodiment of the present disclosure.
Figure 6 is a top view of a lighting component in accordance with a third embodiment of the present disclosure.
Figure 7 is a top view of a lighting device in accordance with a fourth embodiment of the present disclosure.
Figure 8A is a perspective view of a lighting component in accordance with a fifth embodiment of the present disclosure.
Figure 8B is a top view of a lighting component in accordance with the fifth embodiment of the present disclosure.

### DETAILED DESCRIPTION OF DISCLOSED EMBODIMENTS

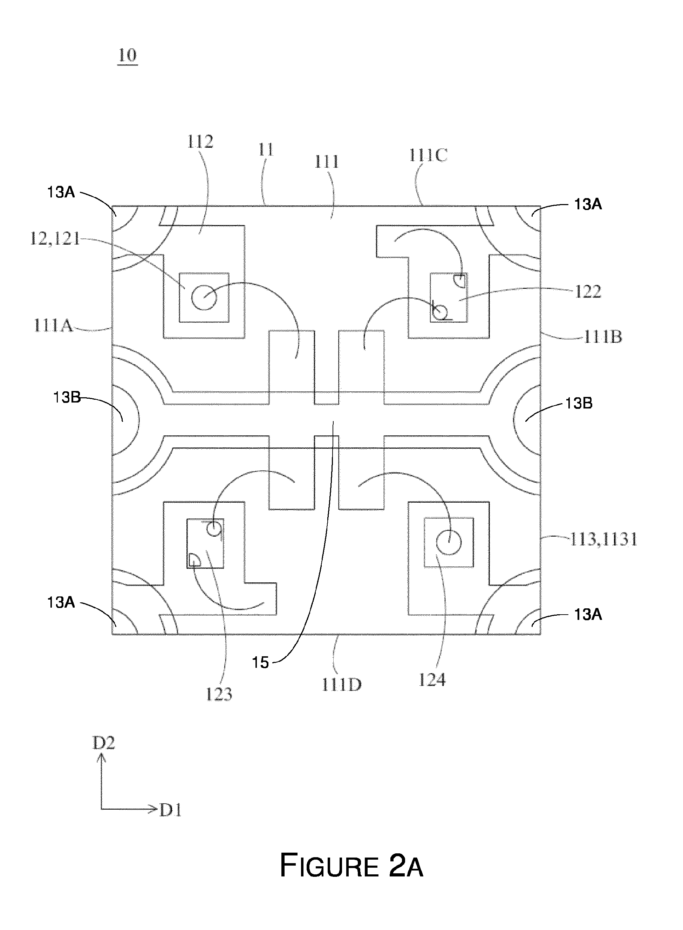

Figure 2A illustrates a top view of a lighting component in accordance with a first embodiment of the present disclosure. In the first embodiment of the present disclosure, a lighting component 10 may include a supporting base 11 and an LED die set 12.

Supporting base 11 may include a supporting surface 111 which may include multiple top electrodes 112 that are separate and electrically insulated from each other. The shape of supporting surface 111 may be quadrilateral (e.g., rectangular or square), round, oval, polygonal, irregular, etc. In one embodiment, supporting surface 111 may be quadrilateral in shape, such as a square. In other words, the four sides of supporting surface 111 may be of equal length.

Irrespective of the shape thereof, supporting surface 111 has a normal direction (not shown), and the two directions perpendicular to the normal direction are defined as a first direction D1 and a second direction D2. The first direction D1 and the second direction D2 are perpendicular to one another. In one embodiment, the first direction D1 may be a horizontal direction and the second direction D2 may be a vertical direction.

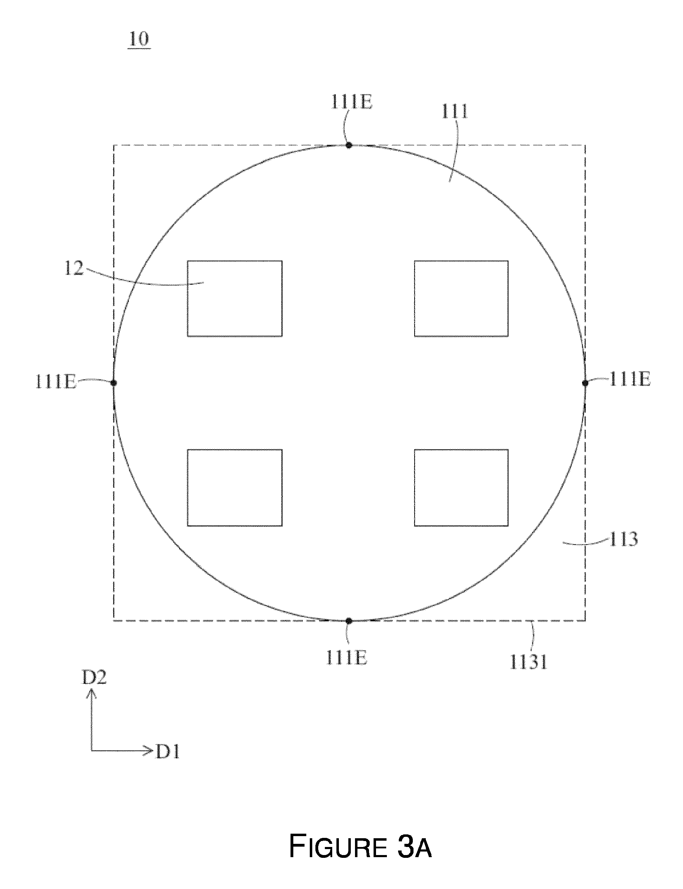

Irrespective of the shape thereof, supporting surface 111 includes two distal ends in the first direction D1 (i.e., the farthest points from a center point of supporting surface 111) and two other distal ends in the second direction D2. In the case that supporting surface 111 is quadrilateral, each of the two distal ends in the first direction D1 may be any point on the two sides 111A and 111 B of supporting surface 111, and each of the two distal ends in the second direction D2 may be any point on the two sides 111C and 111 D of supporting surface 111. In other embodiments, when supporting surface 111 is round (e.g., as shown in Figure 3A), the four distal ends may be four quadrant points 111 E of the round shape.

Referring to Figure 2A, the four distal ends of supporting surface 111 may define an imaginary quadrilateral area 113 with an edge 1131 formed by the four sides of the imaginary quadrilateral area 113. That is, imaginary quadrilateral area 113 has four sides which form the edge 1131 of imaginary quadrilateral area 113.

In the case that supporting surface 111 is quadrilateral, the four sides of imaginary quadrilateral area 113 may be the four sides 111A - 111D of supporting surface 111, and edge 1131 of imaginary quadrilateral area 113 may be the edge of supporting surface 111. In other embodiments, when supporting surface 111 is sound (e.g., as shown in Figure 3A), supporting surface 111 may be a circle inscribed by the imaginary quadrilateral area 113 defined by the four distal ends.

Referring to Figure 2A, LED die set 12 is disposed on supporting surface 111 of supporting base 11, and is electrically connected to top electrodes 112 of supporting surface 111. Top electrodes 112 are further electrically connected to an external power source via the following: (a) corner electrical through holes 13A configured in four corners of the supporting base 11 and (g) bottom electrodes (not shown) disposed on a surface of the supporting base 11 opposite to the supporting surface 111. Furthermore, a common electrode 15 is also electrically connected to an external power source via the following: (a) side electrical through holes 13B on two opposing sides of the supporting base 11 and (b) bottom electrodes (not shown). By this configuration, the light emitting component 10 can be conveniently surface-mounted to any supporting structure. LED die set 12 may include at least a first LED die 121, a second LED die 122, a third LED die 123, and a fourth LED die 124 that are arranged to form in a matrix. Put differently, the first LED die 121 through the fourth LED die 124 are not disposed in a straight line, horizontal line, or diagonal line.

The first LED die 121 through the fourth LED die 124 may be LED dies of different colors. Preferably, the first LED die 121, the second LED die 122, the third LED die 123, and the fourth LED die 124 may be chosen from the following sets: one or two red LED dies, one or two green LED dies, and one or two blue LED dies. In other words, the first LED die 121 through the fourth LED die 124 may include two LED dies of the same color and two LED dies of one or two different colors.

In one embodiment, the first LED die 121 and the fourth LED die 124 may both be red LED dies, with the second LED die 122 being a green LED die and the third LED die 123 being a blue LED die.

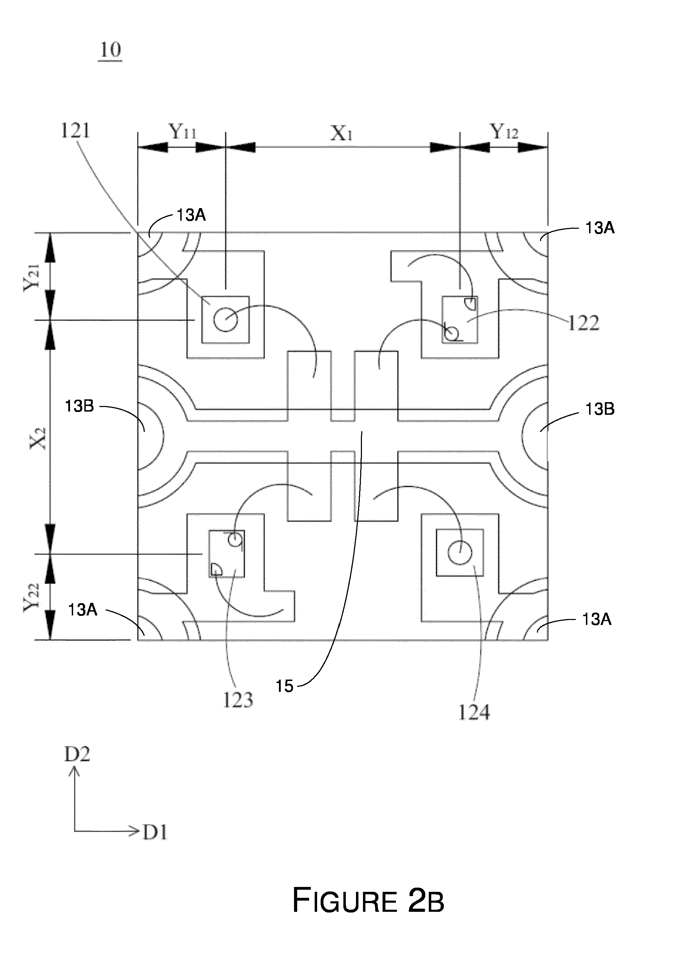

Besides particular colors, there is a particular relationship among the first LED die 121 through the fourth LED die 124 in terms of the location of their disposition, with reference to Figure 2B. Figure 2B illustrates another top view of a lighting component in accordance with the first embodiment of the present disclosure. The lighting component shown in Figure 2B is the same as that shown in Figure 2A, although Figure 2B also shows certain dimensions of the lighting component.

In the first direction D1, a distance between the first LED die 121 and the second LED die 122 has a first value (X₁), a minimum distance between the first LED die 121 and edge 1131 of imaginary quadrilateral area 113 has a second value (Y₁₁), and a minimum distance between the second LED die 122 and edge 1131 of imaginary quadrilateral area 113 has a third value (Y₁₂). The minimum distance between the first LED die 121 (or the second LED die 122) and edge 1131 of imaginary quadrilateral area 113 may refer to the distance between a center point of the first LED die 121 (or the second LED die 122) and a particular side of imaginary quadrilateral area 113. In the case of the first LED die 121, the particular side of imaginary quadrilateral area 113 is one of the sides of imaginary quadrilateral area 113 that is closest to the first LED die 121 in the first direction D1 (e.g., the left side of imaginary quadrilateral area 113 as shown in Figure 2B).

In one embodiment, the first value (X₁) may be greater than the second value (Y₁₁) plus the third value (Y₁₂), or X₁ > (Y₁₁ + Y₁₂). That is, in the first direction D1, the distance between the first LED die 121 and the second LED die 122 is greater than the distance between edge 1131 and each of the first LED die 121 and the second LED die 122.

In one embodiment, with the first LED die 121 through the fourth LED die 124 arranged in an array, the arrangement of the first LED die 121, the second LED die 122 and edge 1131 of imaginary quadrilateral area 113 in the first direction D1 may be reflected in the arrangement of the third LED die 123, the fourth LED die 124 and edge 1131 of imaginary quadrilateral area 113.

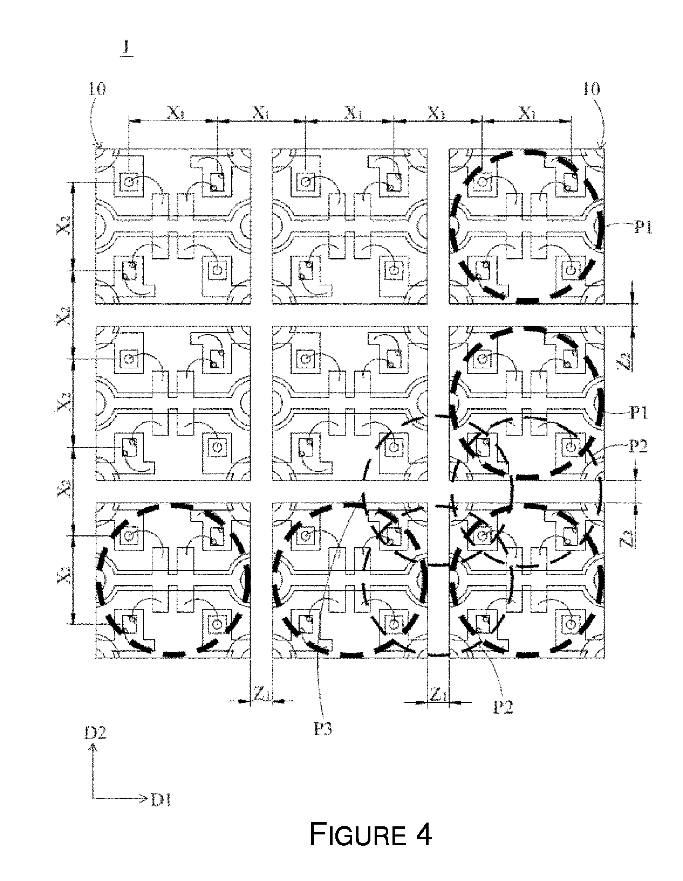

Accordingly, the first LED die 121 through the fourth LED die 124 may define a pixel P1 when emitting light (as shown in Figure 4). In the first direction D1, the second LED die 122 and the fourth LED die 124 may jointly define another pixel P2 (as shown in Figure 4) with one or more LED dies of another lighting component (e.g., as shown in Figure 4 to be described below). Similarly, the first LED die 121 and the third LED die 123 may jointly define another pixel P2 in the first direction D1 with one or more LED dies of another lighting component. Put differently, more than one pixel in the first direction D1 may be defined by lighting component 10, and the pixel pitch between the pixels may be less than the dimension (length or width) of supporting surface 111. In the first direction D1, the pixel pitch between the pixels may be 0.9 or 1.1 times the first value (X₁). More description about this is provided below with respect to the second embodiment of the present disclosure.

The first LED die 121 through the fourth LED die 124 may be arranged similarly in the second direction D2. In the second direction D2, a distance between the first LED die 121 and the third LED die 123 has a fifth value (X₂), a minimum distance between the first LED die 121 and edge 1131 of imaginary quadrilateral area 113 has a sixth value (Y₂₁), and a minimum distance between the third LED die 123 and edge 1131 of imaginary quadrilateral area 113 has a seventh value (Y₂₂).

In one embodiment, the fifth value (X₂) may be greater than the sixth value (Y₂₁) plus the seventh value (Y₂₂), or X₂ > (Y₂₁ + Y₂₂). In other words, in the second direction D2, the distance between the first LED die 121 and the third LED die 123 is greater than the distance between edge 1131 and each of the first LED die 121 and the third LED die 123.

Thus, in the second direction D2, the first LED die 121 and the second LED did 122 may jointly define another pixel P2 (as shown in Figure 4) with one or more LED dies of another lighting component. Similarly, the third LED die 123 and the fourth LED die 124 may jointly define another pixel P2 in the second direction D2 (as shown in Figure 4) with one or more LED dies of another lighting component. That is, more than one pixel in the second direction D2 may be defined by lighting component 10, and the pixel pitch between the pixels may be less than the dimension (length or width) of supporting surface 111. In the second direction D2, the pixel pitch between the pixels may be 0.9 or 1.1 times the fifth value (X₂). More description about this is provided below with respect to the second embodiment of the present disclosure.

On the other hand, when the first LED die 121 through the fourth LED die 124 are arranged in a particular pattern in the first direction D1 and the second direction D2, any of the first LED die 121 through the fourth LED die 124 may define yet another pixel P3 (as shown in Figure 4) with an LED die of each of three other lighting components. That is, four neighboring lighting components 10 may jointly define a pixel P3.

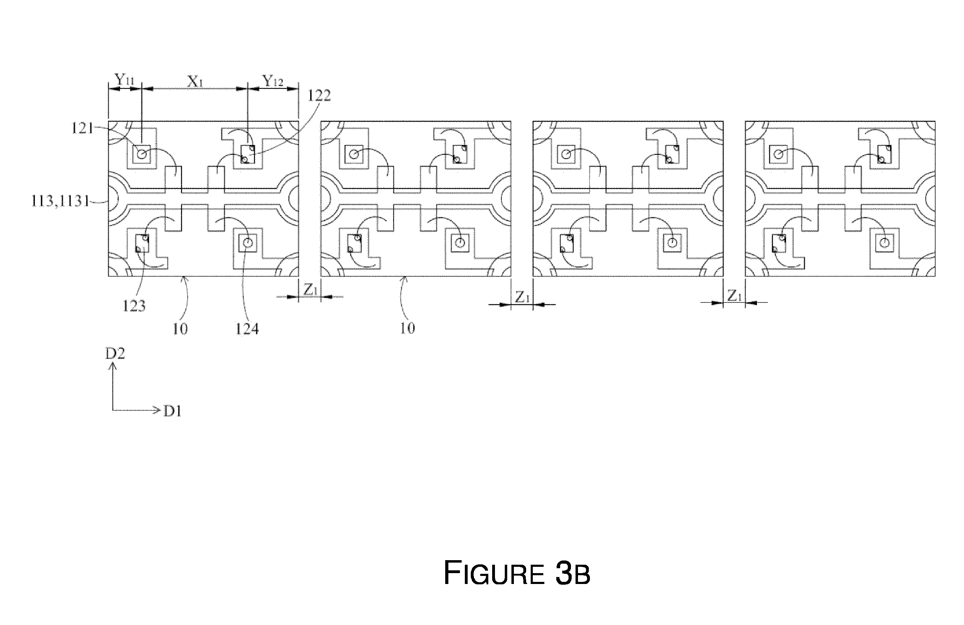

In the aforementioned values, the first value (X₁) and the fifth value (X₂) may be the same. Accordingly, the first LED die 121 through the fourth LED die 124 may be arranged as a square matrix. The second value (Y₁₁) and the third value (Y₁₂) may be the same, and the sixth value (Y₂₁) and the seventh value (Y₂₂) may also be the same. In other embodiments, the second value (Y₁₁) and the third value (Y₁₂) may be different (as shown in Figure 3B), and the sixth value (Y₂₁) and the seventh value (Y₂₂) may also be different (not shown).

Preferably, the first value (X₁) or the fifth value (X₂) is not greater than 1 millimeter (mm). More preferably, the first value (X₁) or the fifth value (X₂) is not greater than 0.8mm. Accordingly, the pixel pitch between the pixels as defined by lighting component 10 is preferably not greater than 1.1mm (i.e., 1.1 times X₁ or X₂) and, more preferably, not greater than 0.88mm (i.e., 1.1 times X₁ or X₂).

Figure 4 illustrates a top view of a lighting device in accordance with a second embodiment of the present disclosure. In the second embodiment of the present disclosure, a lighting device 1 may include multiple lighting components 10.

The multiple lighting components 10 of lighting device 1 may be that of the first embodiment as described above (including the various embodiments described with reference to Figures 3A and 3B). Thus, technical features of the multiple lighting components 10 of lighting device 1 may be the same as that described above. The multiple lighting components 10 may be arranged in an array. In one embodiment, with a quantity of nine, the multiple lighting components 10 may form a 3 x 3 array.

As with the first embodiment, in the first direction D1 or the second direction D2, each of the multiple lighting components 10 may define a pixel P1 (indicated by thick dashed lines), and may jointly define another pixel P2 (indicated by thin dashed lines) with one or more neighboring lighting components 10. Accordingly, in the first direction D1 or the second direction D2, lighting device 1 may provide more pixels in a given unit dimension, and the pixel pitch between the pixels is small (e.g., not greater than 1.1mm). Advantageously, this improves the resolution of lighting device 1.the di

To avoid the visual experience of blurry, twisted or broken pixels P2 as defined by the multiple lighting components 10 when lighting device 1 is viewed by a viewer, preferably the distance between the multiple lighting components 10 may be determined in accordance with the method described below.

In particular, a minimum distance between the edges 1131 of imaginary quadrilateral area 113 of the multiple lighting components 10 in the first direction D1 may be a fourth value (Z₁). That is, a minimum distance between the edge 1131 of supporting surface 111 of one of the multiple lighting components 10 and the edge 1131 of imaginary quadrilateral area 113 of supporting surface 111 of another supporting base 11 in the first direction D1 may be the fourth value (Z₁). The sum of the second value (Y₁₁), the third value (Y₁₂), and the fourth value (Z₁) may be not less than 0.9 times the first value (X₁), and not greater than 1.1 times the first value (X₁), or 0.9 X₁ ≤ (Y₁₁ + Y₁₂ + Z₁) ≤ 1.1X₁.

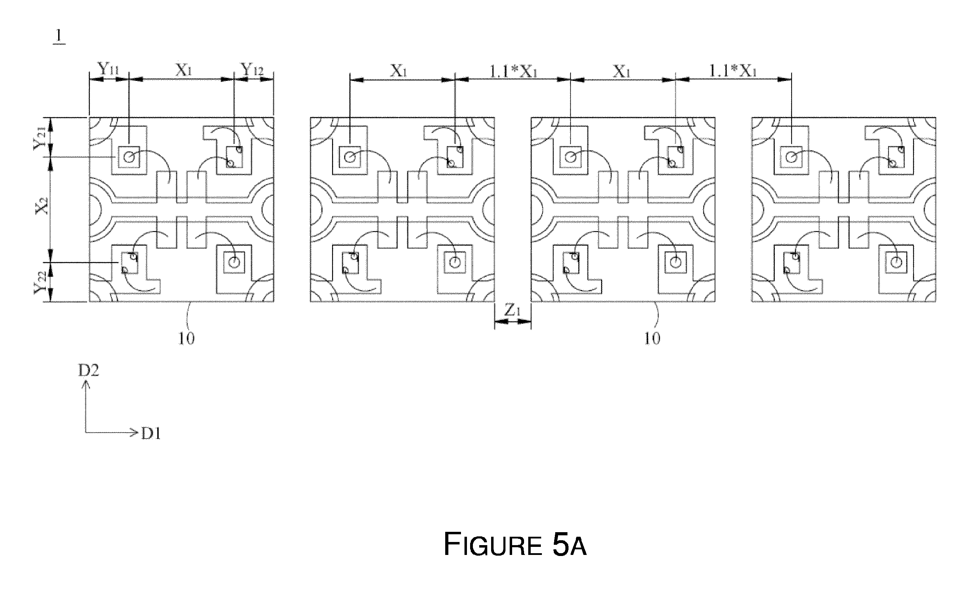

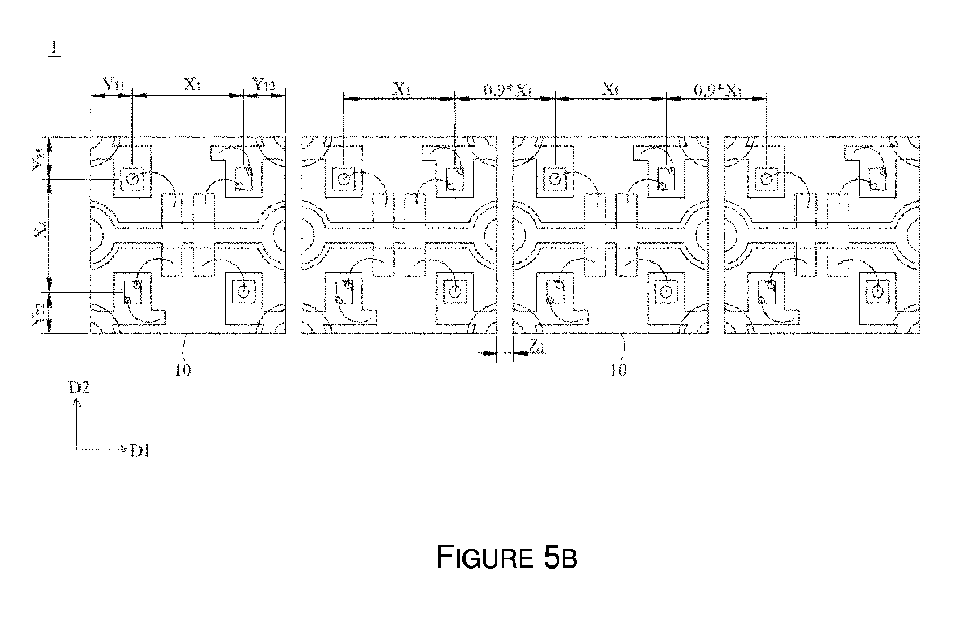

In one embodiment, the sum of the second value (Y₁₁), the third value (Y₁₂), and the fourth value (Z₁) may preferably be equal to the first value (X₁), or X₁ = (Y₁₁ + Y₁₂ + Z₁). In other embodiments, as shown in Figures 5A and 5B, the sum of the second value (Y₁₁), the third value (Y₁₂), and the fourth value (Z₁) may be 1.1 times the first value (X₁), or 0.9 times the first value (X₁). Figures 5A and 5B show a portion of the lighting components 10 of lighting device 1.

In the second direction D2, a minimum distance between the edges 1131 of imaginary quadrilateral area 113 of the multiple lighting components 10 may be an eighth value (Z₂). That is, a minimum distance between the edge 1131 of supporting surface 111 of one of the multiple lighting components 10 and the edge 1131 of imaginary quadrilateral area 113 of supporting surface 111 of another supporting base 11 in the second direction D2 may be the eighth value (Z₂). The sum of the sixth value (Y₂₁), the seventh value (Y₂₂), and the eighth value (Z₂) may be not less than 0.9 times the fifth value (X₂), and not greater than 1.1 times the fifth value (X₂), or 0.9 X₂ ≤ (Y₂₁ + Y₂₂ + Z₂) ≤ 1.1X₂.

In one embodiment, the sum of the sixth value (Y₂₁), the seventh value (Y₂₂), and the eighth value (Z₂) may preferably be equal to the fifth value (X₂), or X₂ = (Y₂₁ + Y₂₂ + Z₂). In other embodiments (not shown), the sum of the sixth value (Y₂₁), the seventh value (Y₂₂), and the eighth value (Z₂) may be 1.1 times the fifth value (X₂), or 0.9 times the fifth value (X₂).

Accordingly, in the first direction D1 or the second direction D2, the visual experience provided to a viewer by the pixels P2 jointly defined by the multiple lighting components 10, and by the pixels P1 individually defined by each of the multiple lighting components 10, may be the approximately the same.

Note that a relationship between the first value (X₁) and the fourth value (Z₁) may be as follows: the first value (X₁) is the sum of the second value (Y₁₁) and the third value (Y₁₂) plus 0.9 to 1.1 times the fourth value (Z₁), or X₁ = Y₁₁ + Y₁₂ + (0.9 ∼ 1.1) · Z₁. A relationship between the fifth value (X₂) and the eight value (Z₂) may be as follows: the fifth value (X₂) is the sum of the sixth value (Y₂₁) and the seventh value (Y₂₂) plus 0.9 to 1.1 times the eighth value (Z2), or X₂ = Y₂₁ + Y₂₂ + (0.9 ∼ 1.1) · Z₂. These relationships may allow the pixels P2 jointly defined by the multiple lighting components 10 to provide enhanced visual experience.

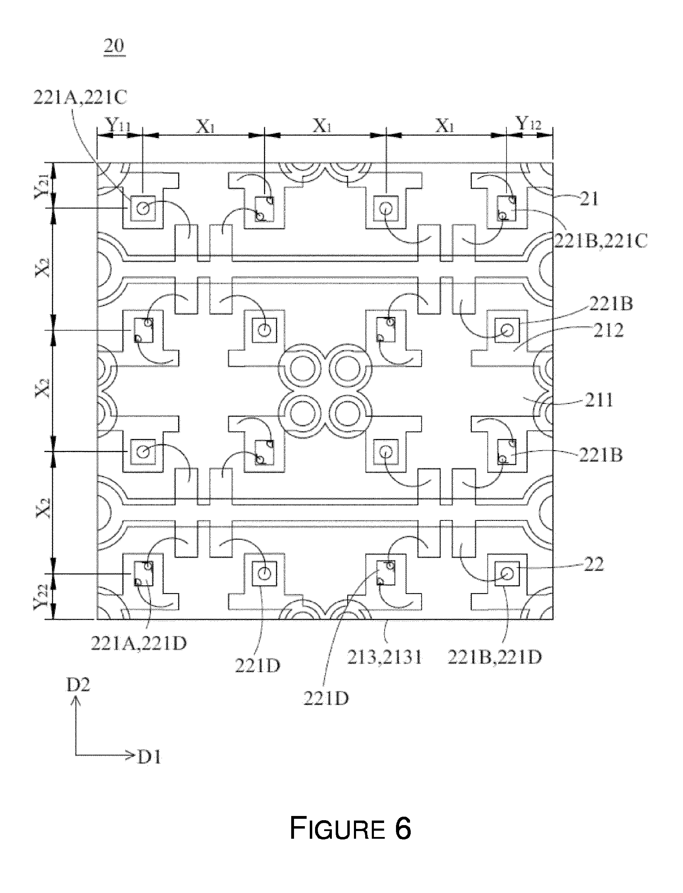

Figure 6 is a top view of a lighting component in accordance with a third embodiment of the present disclosure. In the third embodiment of the present disclosure a lighting component 20 may be provided, which may be similar to the lighting component 10 described above. In the interest of brevity, detailed description of technical features of lighting component 20 may be made with reference to lighting component 10 and, thus, are not repeated herein.

Lighting component 20 may include a supporting base 21 and an LED die set 22. Supporting base 21 may include a supporting surface 211 and multiple electrodes 212. Supporting surface 211 may include two distal ends in the first direction D1 and two other distal ends in the second direction D2. The four terminal ends may jointly define an imaginary quadrilateral area 213 having an edge 2131. The LED die set 22 is disposed on supporting surface 211, and may include at least six LED dies 221 arranged in an array. In one embodiment, a quantity of the multiple LED dies 221 may be sixteen to form a 4 x 4 array.

Depending on the respective location in the array, the multiple LED dies 221 may be further divided into "ones that are disposed on two sides" and "ones that are not disposed on two sides.

In particular, in the first direction D1 the "ones that are disposed on two sides" may be defined as follows: along the first direction D1, those LED dies 221 A that form a first row of the array and those LED dies 221 B that form a last row of the array (i.e., the leftmost four LED dies 221A and the rightmost four LED dies 221 B). In the second direction D2 the "ones that are disposed on two sides" may be defined as follows: along the second direction D2, those LED dies 221C that form a first row of the array and those LED dies 221 D that form a last row of the array (i.e., the uppermost four LED dies 221C and the bottommost four LED dies 221 D).

Those LED dies 221 that do not belong to the "ones that are disposed on two sides" may be defined as "ones that are not disposed on two sides".

The multiple LED dies 221 may be arranged in a particular pattern in the first direction D1. Specifically, in the first direction D1, the distance between any two neighboring ones of the multiple LED dies 221 has a first value (X₁), and a minimum distance between edge 2131 of imaginary quadrilateral area 213 and each of the LED dies 221A and each of the LED dies 221 B on the two sides has a second value (Y₁₁) and a third value (Y₁₂), respectively, with the first value (X₁) greater than the sum of the second value (Y₁₁) and the third value (Y₁₂).

The multiple LED dies 221 may also be arranged in a particular pattern in the second direction D2. In particular, in the second direction D2, the distance between any two neighboring ones of the multiple LED dies 221 has a fifth value (X₂), and a minimum distance between edge 2131 of imaginary quadrilateral area 213 and each of the LED dies 221C and each of the LED dies 221 D on the two sides has a sixth value (Y₂₁) and a seventh value (Y₂₂), respectively, with the fifth value (X₂) greater than the sum of the sixth value (Y₂₁) and the seventh value (Y₂₂).

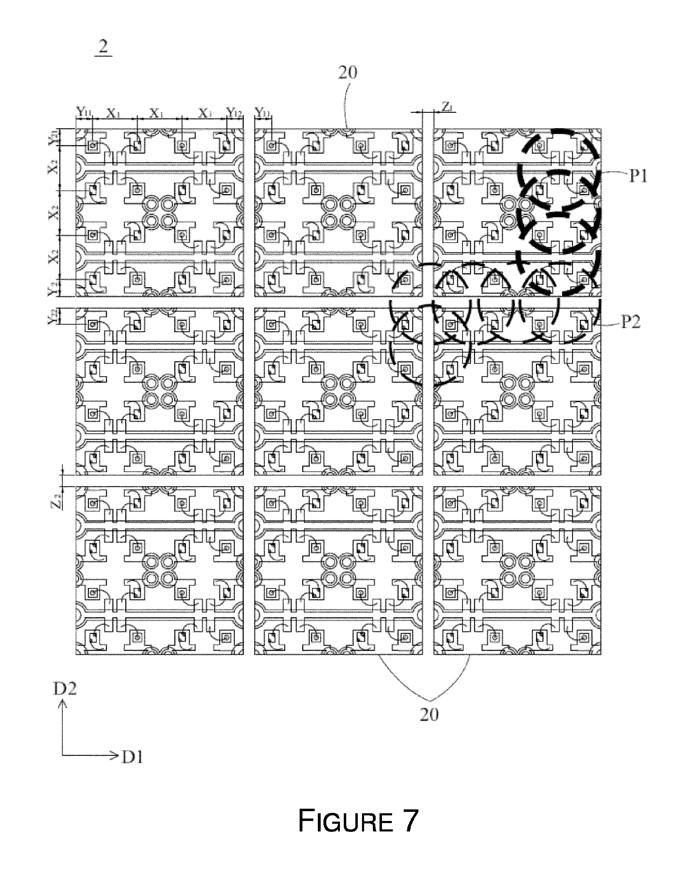

Accordingly, as shown in Figure 7, when numerous lighting components 20 are arranged in a quadrilateral shape to form a lighting device 2, any four neighboring LED dies 221 of each lighting component 20 may define a pixel P1 (indicated by thick dashed lines) in the first direction D1 or the second direction D2. LED dies 221C and 221 D (or LED dies 221A and 221 B) on two sides of the multiple LED dies 221 may jointly define another pixel P2 (indicated by thin dashed lines) with one or more LED dies 221 of one or more neighboring lighting components 20.

On the other hand, the distance between edges 2131 of imaginary quadrilateral area 213 of any two neighboring lighting components 20 has a fourth value (Z₁) in the first direction D1 and an eighth value (Z₂) in the second direction D2. The sum of the second value (Y₁₁), the third value (Y₁₂), and the fourth value (Z₁) may be not less than 0.9 times the first value (X₁), and not greater than 1.1 times the first value (X₁), or 0.9 X₁ ≤ (Y₁₁ + Y₁₂ + Z₁) ≤ 1.1X₁. The sum of the sixth value (Y₂₁), the seventh value (Y₂₂), and the eighth value (Z₂) may be not less than 0.9 times the fifth value (X₂), and not greater than 1.1 times the fifth value (X₂), or 0.9 X₂ ≤ (Y₂₁ + Y₂₂ + Z₂) ≤ 1.1X₂.

Accordingly, in the first direction D1 or the second direction D2, the pixels P2 jointly defined by the multiple lighting components 20 may provide a viewer an enhanced visual experience.

In the interest of brevity, detailed description of the technical features of lighting device 2 may be made with reference to those of lighting device 1 and, hence, are not repeated herein.

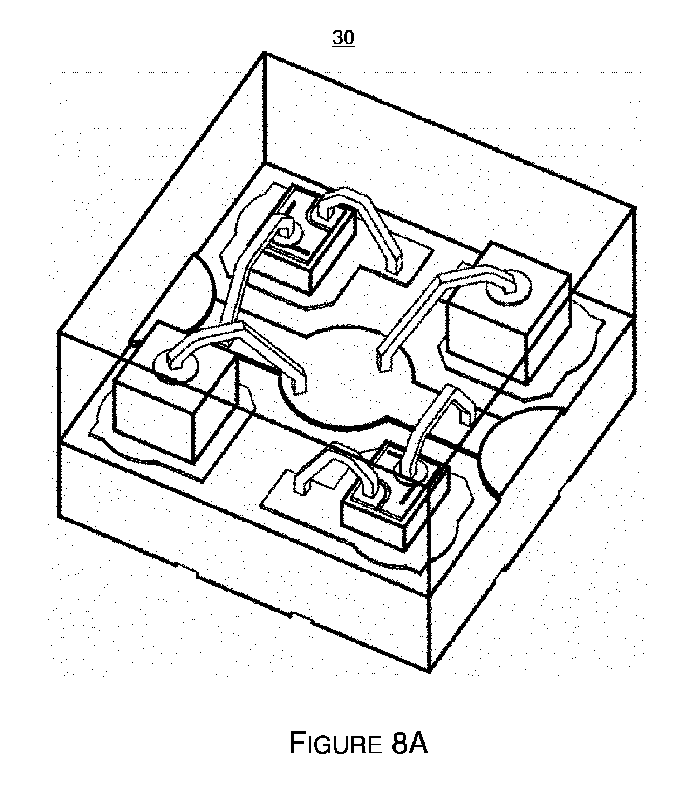

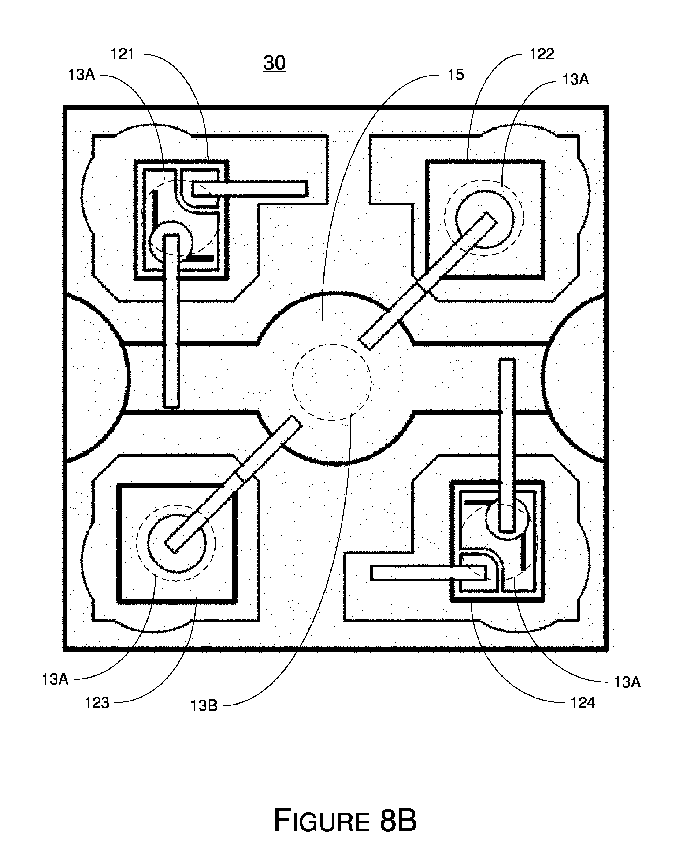

Figure 8A is a perspective view of a lighting component 30 in accordance with a fifth embodiment of the present disclosure. Figure 8B is a top view of the lighting component 30 in accordance with the fifth embodiment of the present disclosure. Compared to other embodiments described above such as lighting components 10 and 20, the form factor (e.g., dimensions) of the lighting component 30 may be further minimized by disposing the electrical through holes 13A directly underneath the LED dies 121, 122, 123 and 124 and/or disposing the electrical through holes 13B directly underneath the common electrode 15, as shown in Figure 8B. With this configuration, there is no electrical through holes around the edges of the supporting base 11, thus further minimizing the dimensions of the lighting component 30. The dimensions of the lighting component 30 in this configuration may be no greater than 0.8mm x 0.8mm (e.g., length by width in the top view as shown in Figure 8B). In one embodiment, the dimensions may range from 0.3mm x 0.3 mm to 0.6mm x 0.6mm approximately (e.g., length by width in the top view as shown in Figure 8B).

In view of the above, various embodiments of the lighting component and lighting device of the present disclosure have a relatively smaller pixel pitch that allows the lighting device to have improved resolution, thus providing enhanced visual experience to a viewer.

### ADDITIONAL NOTES

Embodiments of a lighting component and lighting device in accordance with the present disclosure are not limited to those described herein. The actual design and implementation may vary from the embodiments described herein. Those ordinarily skilled in the art may make various deviations and improvements based on the disclosed embodiments, and such deviations and improvements are still within the scope of the present disclosure. Accordingly, the scope of protection of a patent issued from the present disclosure is determined by the claims as follows.

In the above description of exemplary implementations, for purposes of explanation, specific numbers, materials configurations, and other details are set forth in order to better explain the present disclosure, as claimed. However, it will be apparent to one skilled in the art that the claimed subject matter may be practiced using different details than the exemplary ones described herein. In other instances, well-known features are omitted or simplified to clarify the description of the exemplary implementations.

Moreover, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts and techniques in a concrete fashion. The term "techniques," for instance, may refer to one or more devices, apparatuses, systems, methods, articles of manufacture, and/or computer-readable instructions as indicated by the context described herein.

As used in this application, the term "or" is intended to mean an inclusive "or" rather than an exclusive "or." That is, unless specified otherwise or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more," unless specified otherwise or clear from context to be directed to a singular form.

For the purposes of this disclosure and the claims that follow, the terms "coupled" and "connected" may have been used to describe how various elements interface. Such described interfacing of various elements may be either direct or indirect.

## Claims

1. One or more lighting components, comprising:
a first lighting component, comprising:
a first supporting base having a first supporting surface, the first supporting surface including two distal ends in a first direction and two distal ends in a second direction perpendicular to the first direction, the four distal ends defining a first quadrilateral area; and
a light-emitting diode (LED) die set disposed on the first supporting surface, the LED die set comprising at least a first LED die, a second LED die, a third LED die, and a fourth LED die that are arranged in an array,
wherein a distance between the first LED die and the second LED die in the first direction has a first value X₁, a minimum distance between the first LED die and an edge of the first quadrilateral area has a second value Y₁₁, and a minimum distance between the second LED die and the edge of the first quadrilateral area has a third value Y₁₂, and
wherein the first value X₁ is greater than a sum of the second value Y₁₁ and the third value Y₁₂.

2. The one or more lighting components of Claim 1, further comprising:
a second lighting component, comprising:
a second supporting base having a second supporting surface, the second supporting surface including two distal ends in the first direction and two distal ends in the second direction, the four distal ends of the second supporting surface defining a second quadrilateral area,
wherein a minimum distance between the edge of the first quadrilateral area of the first supporting surface of the first lighting component and an edge of the second quadrilateral area of the second supporting surface of the second lighting component in the first direction has a fourth value Z₁, and
wherein a sum of the second value Y₁₁, the third value Y₁₂, and the fourth value Z₁ is not less than 0.9 times the first value X₁ and not greater than 1.1 times the first value X₁.

3. The one or more lighting components of Claim 2, wherein the sum of the second value Y₁₁, the third value Y₁₂, and the fourth value Z₁ is equal to the first value X₁.

4. The one or more lighting components of Claim 1, wherein a distance between the first LED die and the third LED die in the second direction has a fifth value X₂, wherein a minimum distance between the first LED die and the edge of the first quadrilateral area has a sixth value Y₂₁, wherein a minimum distance between the third LED die and the edge of the first quadrilateral area has a seventh value Y₂₂, and wherein the fifth value X₂ is greater than a sum of the sixth value Y₂₁ and the seventh value Y₂₂.

5. The one or more lighting components of Claim 4, wherein a minimum distance between the edge of the first quadrilateral area of the first supporting surface of the first lighting component and the edge of the second quadrilateral area of the second supporting surface of the second lighting component in the second direction has an eighth value Z₂, and wherein a sum of the sixth value Y₂₁, the seventh value Y₂₂, and the eighth value Z₂ is not less than 0.9 times the fifth value X₂ and not greater than 1.1 times the fifth value X₂.

6. The one or more lighting components of Claim 5, wherein the sum of the sixth value Y₂₁, the seventh value Y₂₂, and the eighth value Z₂ is equal to the fifth value X₂.

7. The one or more lighting components of Claim 1, wherein the first supporting surface is quadrilateral in shape, and wherein the edge of the first quadrilateral area comprises an edge of the first supporting surface.

8. The one or more lighting components of Claim 7, wherein the first supporting surface is square in shape.

9. The one or more lighting components of Claim 1, wherein the first LED die, the second LED die, the third LED die, and the fourth LED die are arranged as a square matrix.

10. The one or more lighting components of Claim 1, wherein the first LED die, the second LED die, the third LED die, and the fourth LED die comprise one or two red LED dies, one or two green LED dies, one or two blue LED dies, or a combination thereof.

11. The one or more lighting components of Claim 1, wherein the first value X₁ is not greater than 1 mm.

12. The one or more lighting components of Claim 1, wherein the fifth value X₂ is not greater than 1 mm.

13. A lighting device, comprising:
a plurality of lighting components, each of the lighting components respectively comprising:
a supporting base having a supporting surface, the supporting surface including two distal ends in a first direction and two distal ends in a second direction perpendicular to the first direction, the four distal ends defining a quadrilateral area; and
a light-emitting diode (LED) die set disposed on the supporting surface, the LED die set comprising at least a first LED die, a second LED die, a third LED die, and a fourth LED die that are arranged in an array,
wherein a distance between the first LED die and the second LED die in the first direction has a first value X₁, a minimum distance between the first LED die and an edge of the quadrilateral area has a second value Y₁₁, and a minimum distance between the second LED die and the edge of the quadrilateral area has a third value Y₁₂,
wherein the first value X₁ is greater than a sum of the second value Y₁₁ and the third value Y₁₂,
wherein the lighting components are arranged in an array,
wherein a minimum distance between the edge of the quadrilateral area of the supporting surface of the supporting base of a first lighting component of the lighting components and the edge of the quadrilateral area of the supporting surface of the supporting base of a second lighting component of the lighting components neighboring the first lighting component in the first direction has a fourth value Z₁, and
wherein a sum of the second value Y₁₁, the third value Y₁₂, and the fourth value Z₁ is not less than 0.9 times the first value X₁ and not greater than 1.1 times the first value X₁.

14. The lighting device of Claim 13, wherein a distance between the first LED die and the third LED die has a fifth value X₂, wherein a minimum distance between the first LED die and the edge of the first quadrilateral area has a sixth value Y₂₁, wherein a minimum distance between the third LED die and the edge of the first quadrilateral area has a seventh value Y₂₂, wherein the fifth value X₂ is greater than a sum of the sixth value Y₂₁ and the seventh value Y₂₂, wherein a minimum distance between the edge of the quadrilateral area of the supporting surface of the supporting base of the first lighting component and the edge of the quadrilateral area of the supporting surface of the supporting base of the second lighting component in the second direction has an eighth value Z₂, and wherein a sum of the sixth value Y₂₁, the seventh value Y₂₂, and the eighth value Z₂ is not less than 0.9 times the fifth value X₂ and not greater than 1.1 times the fifth value X₂.

15. One or more lighting components, comprising:
a first lighting component, comprising:
a first supporting base having a first supporting surface, the first supporting surface including two distal ends in a first direction and two distal ends in a second direction perpendicular to the first direction, the four distal ends defining a first quadrilateral area; and
a light-emitting diode (LED) die set disposed on the first supporting surface, the LED die set comprising at least six LED dies that are arranged in an array,
wherein a distance between two neighboring LED dies of the LED die set in the first direction has a first value X₁, a minimum distance between LED dies of the LED die set on a first side and an edge of the first quadrilateral area has a second value Y₁₁, and a minimum distance between LED dies of the LED die set on a second side opposite the first side and the edge of the first quadrilateral area has a third value Y₁₂, and
wherein the first value X₁ is greater than a sum of the second value Y₁₁ and the third value Y₁₂.

16. The one or more lighting components of Claim 15, further comprising:
a second lighting component, comprising:
a second supporting base having a second supporting surface, the second supporting surface including two distal ends in the first direction and two distal ends in the second direction, the four distal ends of the second supporting surface defining a second quadrilateral area,
wherein a minimum distance between the edge of the first quadrilateral area of the first supporting surface of the first lighting component and an edge of the second quadrilateral area of the second supporting surface of the second lighting component in the first direction has a fourth value Z₁, and
wherein a sum of the second value Y₁₁, the third value Y₁₂, and the fourth value Z₁ is not less than 0.9 times the first value X₁ and not greater than 1.1 times the first value X₁.

17. The one or more lighting components of Claim 16, wherein the sum of the second value Y₁₁, the third value Y₁₂, and the fourth value Z₁ is equal to the first value X₁.

18. The one or more lighting components of Claim 15, wherein a distance between two other neighboring LED dies of the LED die set in the second direction has a fifth value X₂, wherein a minimum distance between the LED dies of the LED die set on the first side and the edge of the first quadrilateral area has a sixth value Y₂₁, wherein a minimum distance between the LED dies of the LED die set on the second side and the edge of the first quadrilateral area has a seventh value Y₂₂, and wherein the fifth value X₂ is greater than a sum of the sixth value Y₂₁ and the seventh value Y₂₂.

19. The one or more lighting components of Claim 18, wherein a minimum distance between the edge of the first quadrilateral area of the first supporting surface of the first lighting component and the edge of the second quadrilateral area of the second supporting surface of the second lighting component in the second direction has an eighth value Z₂, and wherein a sum of the sixth value Y₂₁, the seventh value Y₂₂, and the eighth value Z₂ is not less than 0.9 times the fifth value X₂ and not greater than 1.1 times the fifth value X₂.

20. The one or more lighting components of Claim 19, wherein the sum of the sixth value Y₂₁, the seventh value Y₂₂, and the eighth value Z₂ is equal to the fifth value X₂.
